# EUROPEAN PATENT APPLICATION

(11) **EP 0 598 520 A2**
(43) Date of publication of application: **25.05.1994**
(21) Application number: 93308786.8
(22) Date of filing: 03.11.1993
(51) Int. Cl.: G01R 21/00, G01D 4/00, G01R 11/04, G01R 11/24

(54) **A commodity consumption meter**

(30) Priority: 16.11.1992 GB 9223958
(71) Applicant: THE GENERAL ELECTRIC COMPANY, p.l.c., London W1A 1EH (GB)
(72) Inventor: Jones, Alan John, Stoke-On-Trent, Staffordshire, ST5 3BA (GB); Clowes, Darren James, Stoke-On-Trent, Staffordshire, ST4 8XQ (GB); Forrest, Andrew, Eccleshall, Stafford, ST21 6DS (GB)
(74) Representative: Hoste, Colin Francis

(57) **Abstract**

A commodity consumption meter in the form of a modular assembly comprising: a basic module (1) for metering the consumption of the commodity; and at least one add-on module (3,5) for providing a function ancillary to the metering of the commodity, said meter including a connection (13) consisting of a single plug (24) and socket (23) between said basic module (1) and the or an add-on module (3) by means of which the basic module (1) supplies to the add-on module (3) both power and information regarding the metering by the basic module (1).

## Description

This invention relates to a commodity consumption meter.

According to the present invention there is provided a commodity consumption meter in the form of a modular assembly comprising: a basic module for metering the consumption of the commodity; and at least one add-on module for providing a function ancillary to the metering of the commodity, said meter including a connection consisting of a single plug and socket between said basic module and the or an add-on module by means of which the basic module supplies to the add-on module both power and information regarding the metering by the basic module.

A commodity consumption meter in accordance with the present invention will now be described, by way of example, with reference to the accompanying drawings in which:-
Figure 1 is a schematic diagram of the meter;
Figure 2 shows the appearance of the front face of the meter of Figure 1;
Figure 3 illustrates a connection of the meter of Figure 1;
Figure 4 illustrates signalling employed by the meter of Figure 1;
Figure 5 illustrates a modification to the meter of Figure 1; and
Figure 6 illustrates an alternative modification to the meter of Figure 1.

The commodity the consumption of which is metered by the meter is electricity.

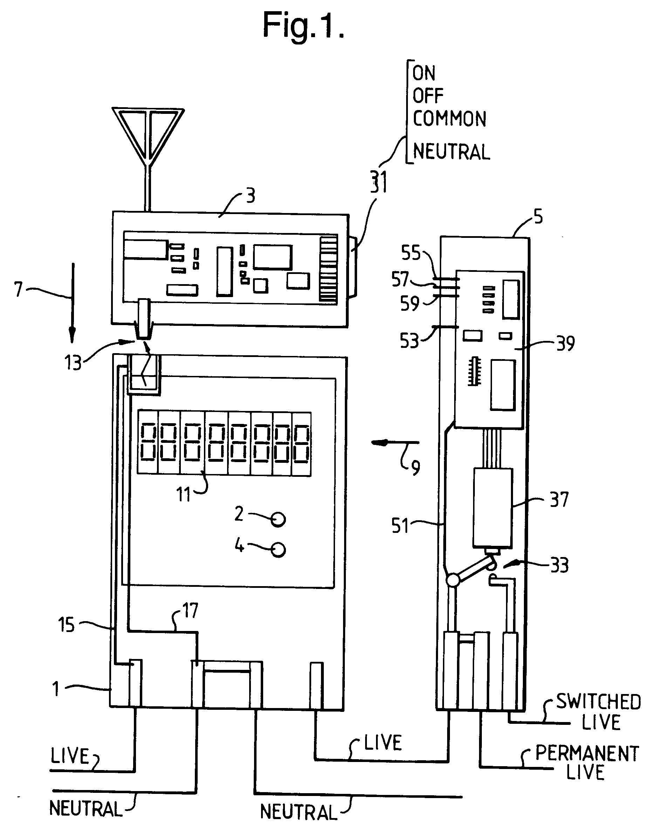

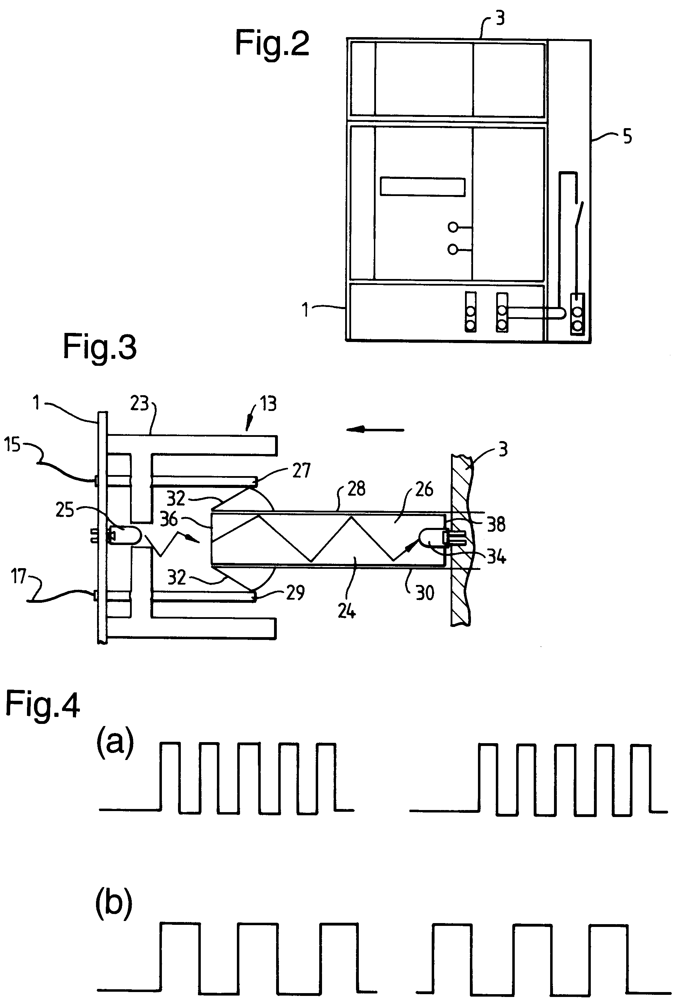

Referring to Figure 1, the meter is in the form of a modular assembly comprising a basic module 1 for metering the consumption of electricity, and two add-on modules 3, 5 for providing functions ancillary to the metering by basic module 1. As indicated by arrows 7, 9 add-on modules 3, 5 are adapted to fit to basic module 1 such that when so fitted the assembly has the appearance of a single unitary module. Figure 2 shows this appearance.

Basic module 1 includes a display 11 and two light emitting diodes 2, 4. Display 11 displays the total amount of electrical energy consumed. Diode 2 pulses on and off after each consumption of a predetermined amount of energy, typically 0.002 kwh. Diode 4 lights up on detection by module 1 of the flow of power away from the consumer, that is in the reverse direction to normal. Reverse flow indicates interference with the meter with a view to taking unmetered electricity.

By means of connection 13 basic module 1 supplies to add-on module 3 both power and information regarding the metering by basic module 1. The power is derived by connection 15, 17 from the live and neutral in-terminals of module 1 and is via a fuse (not shown) to protect module 3. The information supplied is the rate of energy usage and whether the power is forward or reverse flowing.

Add-on module 3 comprises a modem and further circuitry. It implements tariffs, and enables remote reading of the meter, changing of the amounts of the tariffs and the periods over which the tariffs are in force. Module 3 further controls add-on module 5 by means of connections 31 thereto. Module 3 may also enable communication with the consumer, for example to allow the consumer to interrogate the meter to determine the tariff in force at the time of interrogation or the amount of electricity consumed up to the time of interrogation at each one of a number of tariffs. Module 3 is fitted to module 1 by removing a sealed cover (not shown) from module 1 and locking module 3 into place.

Add-on module 5 is a power switch and under the control of module 3 switches on and off the supply of power to the consumer. Module 5 comprises a switch 33 in the live line out from module 1, a contactor 37 for operating switch 33,- and circuitry 39 for driving contactor 37. In addition to the switched live out module 5 has a permanent live out. A connection 51 from the live side of switch 33 is used to power module 5. The neutral return of this power supply is via module 3 by means of neutral connection 53 of connections 31. On and off connections 55, 57 of connections 31 are used by module 3 to send to module 5 low voltage logic level signals to close and open switch 33. Connection 59 of connections 31 is the zero volt connection common to connections 55, 57. Module 5 locks in position to both modules 1 and 3. An example of the use of module 5 is to switch off the power supply to the consumer when reverse power flow indicative of defraudulent interference with the meter is detected.

Referring also to Figure 3, connection 13 between modules 1 and 3 comprises a socket 23 on module 1 and a plug 24 on module 3. At the base of socket 23 is a light emitting diode 25. Socket 23 further comprises upstanding conducting members 27, 29 respectively connected to connections 15, 17 of module 1. Plug 24 comprises an elongate translucent body 26 which carries so as to extend therealong two conductors 28, 30. The end 32 of each conductor 28, 30 remote from the base of plug 24 is so formed as to bias against a respective one of conducting members 27, 29 of socket 23 when plug 24 is inserted into socket 23. Such biassing establishes the supply of power to module 3 as well as securely holding plug 24 in socket 23. At the base of plug 24 is a photosensor 34. The optical properties of translucent body 26 are such that when plug 24 is plugged into socket 23 diode 25 is optically coupled to photosensor 34 via translucent body 26. Thus, light from diode 25 entering end 36 of body 26 passes along the length of body 26 by total internal reflection at its sides to be received by sensor 34 at the other end 38 of body 26.

Diode 25 flashes at a rate indicative of the rate of energy consumption. If there is forward power flow each flash pulse is modulated with a frequency of 8000 Hz. If there is reverse power flow each is modulated with 4000 Hz. Figure 4 shows at (a) two flash pulses each modulated by 8000 Hz to indicate forward flow, and at (b) two flash pusles each modulated by 4000 Hz to indicate reverse power flow. Thus, single diode 25 indicates both rate of energy usage and direction of power flow. Sensor 34 of module 3 receives the signals transmitted by diode 25. Module 3 interprets and processes the received signals.

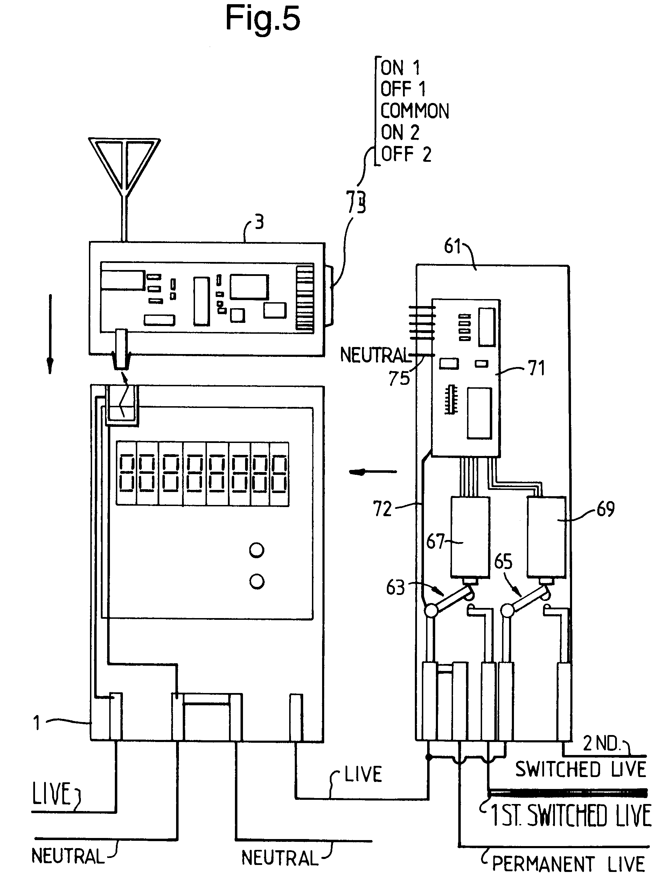

Referring to Figure 5, in the modification module 5 of the meter of Figure 1 comprising a single power switch 33 is replaced by module 61 comprising two power switches 63, 65. Module 61 thus further comprises two contactors 67, 69 and circuitry 71 for driving them. Module 3 sends instruction signals to module 61 by means of connections 73. Module 61 is powered by means of a connection 72 from the live side of switch 63. The neutral return of the supply is via module 3 by means of connection 75. An example of the use of module 61 is for each switch 63, 65 to switch on and off the power to a respective specific load.

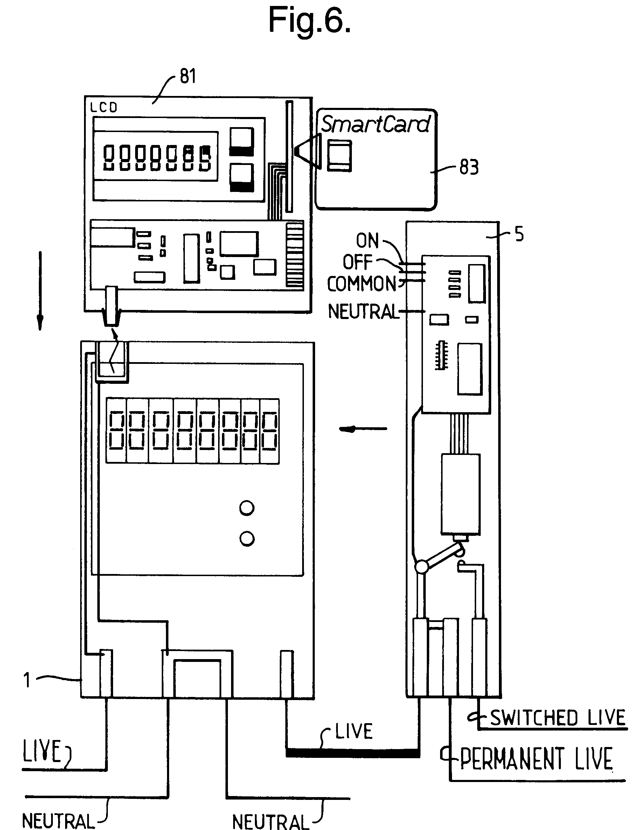

Referring to Figure 6, in the modification module 3 of the meter of Figure 1 is replaced by a module 81 which has the additional facility of prepayment using a smart card 83. On usage of all the prepaid units stored on card 83 module 81 instructs module 5 to disconnect the supply.

It will be appreciated that basic module 1 is basic in the sense that it merely registers the total amount of electricity consumed and provides information as to the rate of energy consumption and the direction of power flow. The other, ancillary functions of the consumption meter are carried out by add-on modules 3, 5, 61, 81. This enables the initial purchase at relatively cheap cost of basic module 1 and the subsequent purchase of add-on modules 3, 5, 61, 81 as further, ancillary functions are required. Add-on modules 3, 5, 61, 81 are adapted to fit to basic module 1 in such a manner as to maintain the appearance of a single commodity consumption metering unit.

## Claims

1. A commodity consumption meter in the form of a modular assembly comprising: a basic module (1) for metering the consumption of the commodity; and at least one add-on module (3,5) for providing a function ancillary to the metering of the commodity, said meter including a connection (13) consisting of a single plug (24) and socket (23) between said basic module (1) and the or an add-on module (3) by means of which the basic module (1) supplies to the add-on module (3) both power and information regarding the metering by the basic module (1).

2. A meter according to Claim 1 wherein: said socket (23) is on said basic module (1) and comprises two upstanding conducting members (27,29) and at the base of the socket (23) a light emitting diode (25); and said plug (24) is on the add-on module (3) and comprises an elongate translucent body (26), two conductors (28,30) carried by the translucent body (26) so as to extend there along, and at the base of the plug (24) a photosensor (34), said power being supplied by means of the electrical contact between each of said conductors (28,30) of the plug (24) and a respective one of said conducting members (27,29) of the socket (23), said information being supplied by means of the optical coupling of said diode (25) of the socket (23) and said photosensor (34) of the plug (24) via said translucent body (26) of the plug (24).

3. A meter according to Claim 1 or Claim 2 wherein: said information is supplied in the form of a single signal and comprises both the rate of consumption of the commodity as metered by the basic module (1) and whether the passage of the commodity is to or away from the consumer.

4. A meter according to Claim 3 wherein: said signal comprises a train of pulses, the rate of occurrence of which is indicative of said rate of consumption, each pulse being modulated with one of first and second modulations the first indicating that said passage is to the consumer the second away.

5. A meter according to any one of the preceding claims which is an electricity consumption meter.

6. A meter according to any one of the preceding claims wherein the or each add-on module (3,5) is adapted to fit to said basic module (1) such that when so fitted the assembly has the appearance of a single unitary module.
